# EUROPÄISCHE PATENTSCHRIFT

(11) **EP 0 387 388 B1**
(45) Veröffentlichungstag und Bekanntmachung des Hinweises auf die Patenterteilung: **11.01.1995**
(21) Anmeldenummer: 89105764.8
(22) Anmeldetag: 01.04.1989
(51) Int. Cl.: H04Q 1/10, H05K 7/14

(54) **Wandzentrale**
Wall exchange
Central mural

(43) Veröffentlichungstag der Anmeldung: 19.09.1990
(73) Patentinhaber: FRIEDRICH MERK-TELEFONBAU GMBH, 85504 Ottobrunn (DE)
(72) Erfinder: Kuhnert, Harald, D-8203 Oberaudorf (DE)

(56) Entgegenhaltungen:
- DE-A- 3 628 833
- DE-A- 3 642 342
- FR-A- 2 361 794
- SIEMENS REVIEW, Band 44, Nr. 5, Mai 1977, Seiten 232-236; H. MASCHGAN:"Packaging system ESA 600 for electronic railway signaling equipment"

## Beschreibung

Die Erfindung betrifft eine Wandzentrale für Fernmelde-, insbesondere Fernsprechanlagen, bestehend aus einer an der Wand befestigten Grundplatte, einem an dieser angebrachten, eine Verdrahtungsplatte mit den Steckanschlüssen für eine Vielzahl von Baugruppen aufweisenden, die Baugruppen aufnehmenden Baugruppenrahmen, und einer Schutzkappe.

Eine derartige Wandzentrale ist bereits bekannt. So wird in der DE-AS 28 46 825 eine Wandzentrale für Fernsprechanlagen, insbesondere Reihenanlagen beschrieben, bei der eine Grundplatte an der Wand befestigt ist und die elektrische Verbindung zwischen der Grundplatte und dem Bauteileträger über Anschlußleisten erfolgt. Der Bauteileträger wird schräg nach vorn eingesetzt und durch Schwenken zur Wand mit der Grundplatte verriegelt. Über den Anschluß der Anschlußleitungen in der Wandzentrale lassen sich der genannten Druckschrift keine Angaben entnehmen.

Die Aufgabe der Erfindung besteht nun darin, eine Wandzentrale anzugeben, deren Aufbau den Anschluß der Anschluß- und Verbindungsleitungen erleichtert und eine einfachere Montage und Wartung der Anlage ermöglicht.

Diese Aufgabe wird dadurch gelöst, daß die Grundplatte eine seitliche Aufnahme aufweist, welche einen senkrecht an der Wand angebrachten Kabelkanal übergreift und daß der Anschluß der Kabel des Kabelkanals an Einrichtungen zum Schutz gegen Überspannungen, Blitzschutzableiter, usw., tragende Anschlußbaugruppen über jeweils einen für eine Anschlußbaugruppe gemeinsamen Anschlußstecker erfolgt, welcher auf die Vorderseite der eingeschobenen Anschlußbaugruppe steckbar ist. Der Kabelkanal reicht in die Grundplatte und damit auch in das Gehäuse der Wandzentrale hinein, wodurch sich die Kabeladern der in dem Kabelkanal befindlichen Kabel leicht an die Anschlußbaugruppen heranführen lassen. Durch die Steckverbindung zwischen Kabel und Anschlußbaugruppe läßt sich leicht der Baugruppenrahmen von den Anschluß- und Verbindungsleitungen für Wartungsarbeiten trennen.

Eine Weiterbildung der Erfindung besteht darin, daß die Grundplatte oberhalb der Unterkante nach oben gerichtete Nasen aufweist, welche jeweils hinter einen oberen Vorsprung eines an der Wand befestigten Halteblechs greifen.

Das Halteblech dient zur Befestigung einer weiteren Grundplatte unterhalb einer bereits montierten Grundplatte, auf diese Weise kann leicht ein weiteres Wandzentralengehäuse unterhalb eines bereits befestigten Wandgehäuses angebracht werden.

Vorteilhafte Weiterbildungen der Erfindung ergeben sich aus den Unteransprüchen.

Die Erfindung wird anhand eines Ausführungsbeispiels näher erläutert, welches in der Zeichnung dargestellt ist.

Es zeigt:

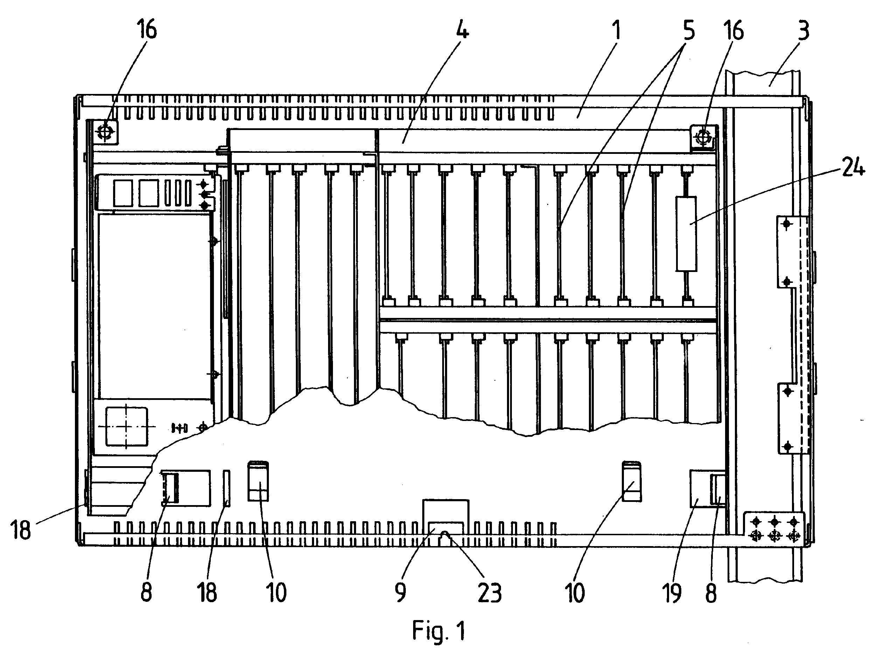

- Fig. 1: eine Draufsicht auf die an der Wand befestigte Wandzentrale bei abgenommener Schutzkappe,
- Fig. 2: die Seitenansicht der an der Wand befestigten Grundplatte,

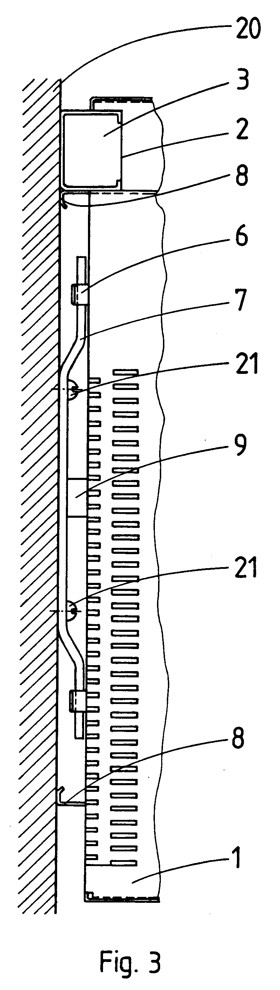

- Fig. 3: die Ansicht von oben auf die an der Wand befestigte Grundplatte,

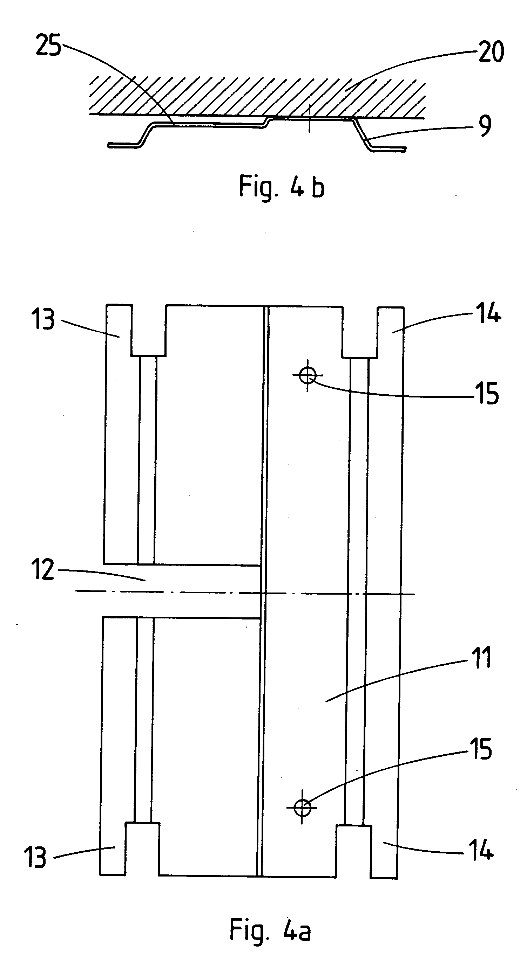

- Fig. 4a: die Draufsicht auf das Halteblech,
- Fig. 4b: die Seitenansicht des Halteblechs und

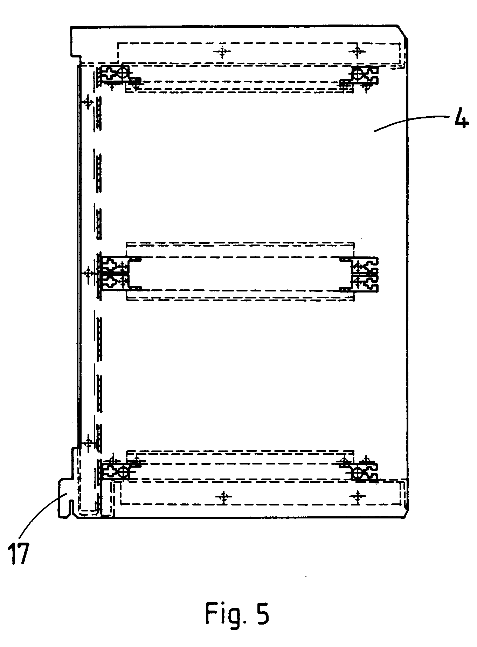

- Fig. 5: die Seitenansicht des Baugruppenrahmens.

Das Gehäuse für eine Wandzentrale einer Fernmelde- insbesondere Fernsprechvermittlungsanlage wird durch eine Grundplatte 1 und eine nicht gezeigte Schutzkappe gebildet.

Die Grundplatte 1 weist auf ihrer der Wand zugewandten Seite unterhalb der Oberkante zwei nach unten gerichtete Nasen auf, welche über die beiden Schenkel des aus einem gekröpften Flacheisen bestehenden Bügels 7 greifen, der waagerecht mit Schrauben 21 an der Wand 20 befestigt ist. Oberhalb der Unterkante sind zwei Abstandshalter 8 angebracht, welche für den entsprechenden Abstand zwischen Wand 20 und Grundplatte 1 sorgen. Außerdem ist oberhalb der Unterkante ein Befestigungswinkel 9 angebracht, mit welchem die Grundplatte 1 über einen dritten Punkt mit der Wand 20 befestigt ist, und zwar durch eine nicht gezeigte Schraube, welche durch die Bohrung 23 des Befestigungswinkels 9 die Verbindung mit der Wand 20 herstellt.

Die Grundplatte 1 weist eine Aufnahme 2 auf, welche über einen senkrecht an der Wand befestigten Kabelkanal 3 greift. Dieser Kabelkanal, der außerhalb der Grundplatte 1 abgedeckt ist, enthält Kabel mit Anschluß- und Verbindungsleitungen, die über jeweils Stecker 24 mit den Anschlußbaugruppen 5 verbunden werden, und zwar werden die Anschlußstecker 24 auf die Anschlußbaugruppen im eingeschobenen Zustand gesteckt, wenn diese sich im Baugruppenrahmen 4 befinden.

Die Anschlußbaugruppen 5 tragen Einrichtungen zum Schutz gegen Überspannungen, Blitzschutzableiter, usw., für jede Anschlußbaugruppe 5 ist ein gemeinsamer Anschlußstecker 24 vorhanden, welcher auf die Vorderseite der eingeschobenen Anschlußbaugruppe 5 aufsteckbar ist. Der Baugruppenrahmen 4 weist auf der der Grundplatte zugewandten Seite, und zwar oberhalb der Unterkante Haken 17 auf, welche in Schlitze 18 bzw. in eine Öffnung 19 eingehängt werden. Weiterhin wird der Baugruppenrahmen 4 an der Grundplatte durch Schnellverschlüsse 16 an der Grundplatte 1 gehalten, die im oberen Bereich des Baugruppenrahmens 4 angebracht sind. Anstelle der Schnellverschlüsse 16 kann selbstverständlich auch eine normale Schraubverbindung treten.

Die Grundplatte 1 weist oberhalb der Unterkante auf der der Wand 20 zugewandten Seite nach oben gerichtete Nasen 10 auf, welche hinter die beiden oberen Vorsprünge 13 eines Halteblechs 11 greifen. Das Halteblech 11 weist außerdem untere Vorsprünge 14 auf, in welche die nach unten gerichtete Nasen 6 einer weiteren Grundplatte 1 eingehängt werden, wenn ein weiteres Gehäuse einer Wandzentrale benötigt wird. Das Halteblech 11 weist außerdem eine Öffnung 12 auf, so daß es möglich ist, im montiertem Zustand der ersten Grundplatte 1 das Halteblech 11 von unten zwischen die Wand 20 und die Grundplatte 1 einzuführen und in die nach oben gerichteten Nasen 10 einzuhängen. Zu diesem Zweck steht der die oberen Vorsprünge tragende Teil 25 des Halteblechs 11 etwas von der Wand ab, damit Platz für die notwendige Schwenkbewegung vorhanden ist. Nach dem Einhängen wird das Halteblech 11 mit Schrauben durch die Bohrungen 15 an der Wand 20 befestigt.

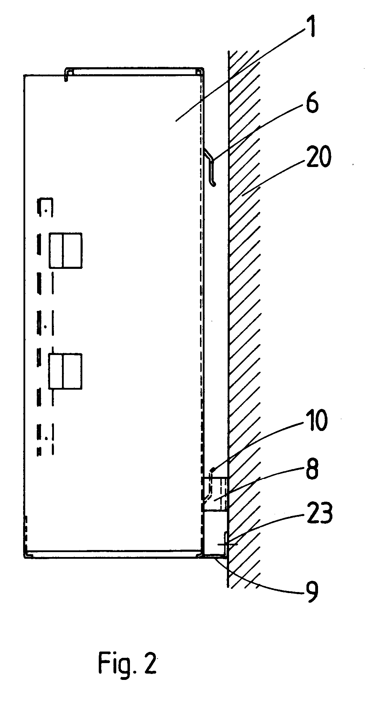

Die Seitenteile der Grundplatte 1 sind etwas hochgezogen (s. Fig. 2), auf die derart gestaltete Grundplatte wird eine nicht gezeigte Schutzkappe aufgestülpt, die durch nicht gezeigte seitliche Schnappverbindungen gehalten wird. Zum besseren Verständnis der Ausformung der Nasen 6 und 10 wird in Fig. 2 die an der Wand 20 gezeigte Grundplatte 1 ohne den Bügel 7 gezeigt.

Der Anschlußstecker 24 kann in Schneidklemmtechnik ausgebildet sein, wobei der Anschluß der Leitungen der Kabel an den Schneidklemmverbindern des Anschlußsteckers 24 erfolgt.

Die Grundplatte ist aus Blech gefertigt, wobei der Befestigungswinkel 9 und die Abstandshalter 8 als Blechlappen aus der aus Blech bestehenden Grundplatte 1 herausgebogen sind. Die Abstandshalter 8 können beispielsweise mit Hilfe einer Zange verbogen werden, um den Abstand zwischen der Grundplatte 1 und der Wand 20 zu verändern, falls die Wand 20 nicht ganz plan ist.

## Patentansprüche

1. Wandzentrale für Fernmelde-, insbesondere Fernsprechanlagen, bestehend aus einer an der Wand befestigten Grundplatte, einem an dieser angebrachten, eine Verdrahtungsplatte mit den Steckanschlüssen für eine Vielzahl von Baugruppen aufweisenden, die Baugruppen aufnehmenden Baugruppenrahmen, und einer Schutzkappe,
dadurch gekennzeichnet,
daß die Grundplatte (1) eine seitliche Aufnahme (2) aufweist, welche einen senkrecht an der Wand (20) angebrachten Kabelkanal (3) übergreift, und daß der Anschluß der Kabel des Kabelkanals (3) an Einrichtungen zum Schutz gegen Überspannungen, Blitzschutzableiter, usw. tragende Anschlußbaugruppen (5) über jeweils einen für eine Anschlußbaugruppe gemeinsamen Anschlußstecker (24) erfolgt, welcher auf die Vorderseite der eingeschobenen Anschlußbaugruppe (5) steckbar ist.

2. Wandzentrale nach Anspruch 1,
dadurch gekennzeichnet,
daß der Baugruppenrahmen (4) an der der Grundplatte (1) zugewandten Seite Haken (17) zum Einhängen in entsprechende Schlitze (18) bzw. Öffnungen (19) der Grundplatte (1) und Schnellverschlüsse (16) zur Befestigung mit der Grundplatte (1) aufweist.

3. Wandzentrale nach einem der Ansprüche 1 oder 2,
dadurch gekennzeichnet,
daß die Grundplatte (1) nach unten gerichtete Nasen (6) aufweist, welche über die abgekröpften Schenkel eines an der Wand (20) befestigten Bügels (7) greifen.

4. Wandzentrale nach einem der Ansprüche 1 bis 3,
dadurch gekennzeichnet,
daß die Nasen (6) unterhalb der Oberkante der Grundplatte (1) angebracht sind und daß oberhalb der Unterkante der Grundplatte (1) ein Befestigungswinkel (9) mit einer Bohrung (23) zur Befestigung mit einer Schraube an der Wand (20) vorgesehen ist.

5. Wandzentrale nach einem der Ansprüche 1 bis 4,
dadurch gekennzeichnet,
daß oberhalb der Unterkante der Grundplatte (1) seitlich Abstandshalter (8) zur Wand (20) angebracht sind.

6. Wandzentrale nach einem der Ansprüche 1 bis 5,
dadurch gekennzeichnet,
daß die Grundplatte (1) oberhalb der Unterkante nach oben gerichtete Nasen (10) aufweist, welche jeweils hinter einen oberen Vorsprung (13) eines an der Wand (20) befestigten Halteblechs (11) greifen.

7. Wandzentrale nach Anspruch 6,
dadurch gekennzeichnet,
daß das Halteblech (11) untere Vorsprünge (14) aufweist, welche jeweils eine nach unten gerichtete Nase (6) der Grundplatte (1) aufnehmen.

8. Wandzentrale nach einem der Ansprüche 6 oder 7,
dadurch gekennzeichnet,
daß der die oberen Vorsprünge (13) tragende Teil (25) des Halteblechs (11) von der Wand (20) absteht und eine Öffnung (12) aufweist.

9. Wandzentrale nach einem der vorhergehenden Ansprüche,
dadurch gekennzeichnet,
daß an dem Anschlußstecker (24) die Leitungen der Kabel in Schneidklemmtechnik angeschlossen sind.

10. Wandzentrale nach einem der vorhergehenden Ansprüche,
dadurch gekennzeichnet,
daß die Grundplatte (1) aus Blech besteht und die Abstandshalter (8) als Blechlappen ausgebildet sind.

## Claims

1. Wall-mounted exchange unit for telecommunications, especially telephone, installations, consisting of a base plate fastened to the wall, a subassembly frame, which is mounted thereon, has a wiring board with the plug connections for a plurality of subassemblies and which receives the subassemblies, and a protective cap, characterised thereby that the base plate (1) has a lateral receptacle (2) which engages over a cable duct (3) mounted vertically at the wall (20) and that the connection of the cable of the cable duct (3) to devices for protection against voltage overloads, terminal subassembly groups (5) carrying lightning protection conductors, etc., is effected by way of a respective connecting plug (24) which is common to a terminal subassembly group and which is pluggable onto the front side of the inserted terminal subassembly group (5).

2. Wall-mounted exchange unit according to claim 1, characterised thereby that the subassembly frame (4) has, at the side facing the base plate (1), hooks (17) for suspension in corresponding slots (18) or openings (19) of the base plate (1) and snap closures (16) for fastening with the base plate (1).

3. Wall-mounted exchange unit according to one of claims 1 or 2, characterised thereby that the base plate (1) has downwardly directed lugs (6), which engage over the offset limb of a bracket (7) fastened to the wall (20).

4. Wall-mounted exchange unit according to one of claims 1 to 3, characterised thereby that the lugs (6) are mounted below the upper edge of the base plate (1) and that a fastening angle bracket (9) with a bore (9) for fastening to the wall (2a) by a screw is provided above the lower edge of the base plate (1).

5. Wall-mounted exchange unit according to one of claims 1 to 4, characterised thereby that lateral spacers (8) relative to the wall (2a) are mounted above the lower edge of the base plate (1).

6. Wall-mounted exchange unit according to one of claims 1 to 5, characterised thereby that the base plate (1) has upwardly directed lugs (10), which each engage behind a respective upper projection (13) of a sheet metal retaining plate (11) fastened to the wall (20), above the lower edge.

7. Wall-mounted exchange unit according to claim 6, characterised thereby that the sheet metal retaining plate (11) has lower projections (14), which each receive a respective downwardly directed lug (6) of the base plate (1).

8. Wall-mounted exchange unit according to one of claims 6 or 7, characterised thereby that the part (25), which carries the upper projections (13), of the sheet metal retaining plate (11) is spaced from the wall (20) and has an opening (12).

9. Wall-mounted exchange unit according to one of the preceding claims, characterised thereby that the leads of the cable are connected to the connection plug (24) in cut-clamping technique.

10. Wall-mounted exchange unit according to one of the preceding claims, characterised thereby that the base plate (1) consists of sheet metal and the spacers (8) are constructed as sheet metal tongues.

## Revendications

1. Central mural pour installation de télécommunication, en particulier téléphonique, se composant d'une plaque de base fixée sur un mur, d'un châssis de blocs élémentaires rapporté sur la plaque, présentant une plaque de câblage comportant des prises de courant embrochables pour une pluralité de blocs, et accueillant les blocs, et un capuchon de protection, caractérisé en ce que la plaque de base (1) comporte un logement latéral (2) qui recouvre un caniveau à câbles (3) supporté perpendiculairement au mur (20), et en ce que la connexion des câbles du caniveau à câbles (3) sur les blocs de connexion (5) portant des dispositifs de protection contre les surtensions, la foudre etc..., est réalisée par l'intermédiaire d'une fiche de connexion (24) commune pour un bloc de connexion, fiche qui est embrochable sur la face avant du bloc de connexion (5) renforcé.

2. Central selon la revendication 1, caractérisé en ce que le châssis de blocs élémentaires (4) comporte, sur le côté adjacent à la plaque de base (1), des crochets (17) pour l'accrochage dans des fentes (18) et/ou ouvertures (19) correspondantes de la plaque de base (1), ainsi que des fermetures rapides (16) de fixation sur la plaque de base (1).

3. Central selon la revendication 1 ou 2, caractérisé en ce que la plaque de base (1) présente des taquets (6) dirigés vers le bas, qui sont en prise avec la partie coudée d'une traverse (7) fixée contre le mur (20).

4. Central selon l'une des revendications 1 à 3, caractétérisé en ce que les taquets (6) sont rapportés sous le bord supérieur de la plaque de base, et en ce qu'est prévu, au-dessus du bord inférieur de la plaque de base (1) un coude de fixation (9) comportant un trou (23) permettant la fixation sur le mur (20) au moyen d'une vis.

5. Central selon l'une des revendications 1 à 4, caractérisé en ce que, au-dessus du bord inférieur de la plaque de base, sont rapportées des entretoises (8) latéralement par rapport au mur (20).

6. Central selon l'une des revendications 1 à 5, caractérisé en ce que la plaque de base (1) présente, au-dessus de son bord inférieur, des taquets (10) dirigés vers le haut, qui viennent en prise derrière une saillie (13) dirigée vers le haut d'une plaque d'arrêt (11) fixée sur le mur (20).

7. Central selon la revendication 6, caractérisé en ce que la plaque d'arrêt (11) présente des saillies (14) dirigées vers le bas qui reçoivent chacune un taquet (6) dirigé vers le bas de la plaque de base (1).

8. Central selon la revendication 6 ou 7, caractérisé en ce que la partie (25) de la plaque d'arrêt (11), qui supporte la saillie (13) dirigée vers le haut, est écartée du mur (20) et présente une ouverture (12).

9. Central selon l'une des revendications précédentes, caractérisé en ce que les lignes de câbles sont connectées au niveau de la fiche de connexion (24) selon la technique du sertissage.

10. Central selon l'une des revendications précédentes, caractérisé en ce que la plaque de base (1) est en tôle et en ce que les entretoises (8) sont formées de languettes de tôle.
